# EUROPEAN PATENT APPLICATION

(11) **EP 4 008 953 A1**
(43) Date of publication of application: **08.06.2022**
(21) Application number: 20211198.5
(22) Date of filing: 02.12.2020
(51) Int. Cl.: F21V 29/51, F21V 29/503, F21V 29/89, F21S 8/08, F28D 15/02, F21Y 105/10, F21Y 115/10, F21W 131/103

(54) **LED LIGHT FITTING WITH A COOLING SYSTEM**

(71) Applicant: NoelleLED Sp. z o.o., 10-683 Olsztyn (PL)
(72) Inventor: Maciaszek, Andrzej, 09-400 Plock (PL)
(74) Representative: Wroblewski, Marcin Jan

(57) **Abstract**

An LED light fitting (1) comprising a cover (2), an LED matrix (3), between which a cooling system (4) is arranged, adapted to transport heat from the LED matrix (3) to the cover (2), wherein the cooling system (4) comprises a heat transfer plate (5) connected to the LED matrix (3) and a coolant circulation module (6) connected to the heat transfer plate (5) and to the cover (2), the said coolant circulation module (6) comprises an evaporation section (7) connected to the heat transfer plate (5) and a condensation section (8) connected to the inner surface of the cover (2), wherein the module (6) comprises at least one channel (9) with at least one chamber (10) for transporting the coolant from the evaporation section (7) to the condensation section (8) and with at least one chamber (11) for transporting the coolant from the condensation section (8) to the evaporation section (7).

An LED light fitting comprising an LED matrix (22), a communication module (23) and a control and power supply system (24) comprising a control microprocessor (25), a first voltage regulation module (26) for lowering the mains voltage, a second voltage regulation module (27) for controlling the light beam emitted by the LED matrix, wherein the output lᵢ of the first voltage regulation module (26) is connected to the input sᵢ of the control microprocessor (25), where i = (1, 2, ... , n), the output tᵢ of the control microprocessor (25) is connected to the input mᵢ of the second voltage regulation module (27), where i = (1, 2,..., n), and the output oᵢ of the second voltage regulation module (27) is connected to the input uᵢ of the LED matrix (22), where i = (1, 2, ... , n), characterised in that the control microprocessor (25) is adapted to continuous two-way communication with the communication module (23), and the control and power supply system (24) further comprises a third voltage regulation module (28) for supplying the remaining electrical components of the fitting, wherein tᵢ₊₁ the output of the control microprocessor (25) is connected to the input pᵢ of the third voltage regulation module (28), where i = (1, 2, ... , n).

## Description

### Field of the Invention

The object of the invention is an LED light fitting with a cooling system, especially a street light fitting. Moreover, the object of the invention is a LED light fitting with a control and power supply system.

### Description of Prior Art

From the Chinese utility model CN210107301U, a LED light fitting is known having a transparent cover (lampshade) and an LED matrix which are cooled using a system comprising a cooling chamber filled with a coolant. The said chamber is connected to pipes for condensing the refrigerant. The pipes, in turn, are equipped with graphite rods to remove heat from the coolant to an aluminium plate with ribbed elements. The said plate is embedded in the upper part of the fitting. The cooling system further comprises a flange in the form of rings to which a coolant is supplied with a circulating pump. The said flange surrounds the transparent cover. The system also comprises a heat-conducting copper core to which an LED matrix is attached. The said core is located under the cooling chamber. In the described solution, the excess heat is removed from the space inside the lampshade.

From the US patent application US2018331267A1, a lamp is known having an LED matrix adjacent to a metal layer which may be made of copper, silver or gold. The said layer is adjacent to another metal layer which may be made of aluminium or magnesium. The said aluminium or magnesium layer is in turn adjacent to a cooling element. This element can be made of silver, copper or gold. Furthermore, it may comprise slots containing plates made of aluminium. Each of the said aluminium elements may have a thickness of 0.5 to 12 mm. Furthermore, the cooling element comprises heat pipes adapted to transport a coolant, for example water. Each of the pipes has an evaporating section and a coolant condensation section. The pipes may be parallel or perpendicular to the direction of the main beam of LED elements. The pipes may also be perpendicular and/or horizontal to the mounting surface of the LED matrix. Furthermore, the lamp may contain an additional cooling element in the form of a ribbed heat sink.

From the Chinese utility model CN206280932U a cooling system for LED lamps is known, consisting of a heat sink and heat pipes. Connected in series, the heat pipes are in the form of a duplicated letter S. The heat sink is an evaporator chamber to which the heat pipes are connected. In turn, the bottom surface of the evaporator chamber is the plane to which the LED matrix is adjacent.

Furthermore, from the American patent US9435524B2 an LED lighting system, e.g. a lamp, is known in which individual devices are cooled by means of a tubular system adapted to transport a coolant.

In turn, from the American patent US8564741B2 a liquid crystal display comprising a backlight in the form of LED diodes and a cooling device is known. In turn, the cooling device comprises a pipe for transporting a coolant, the coolant, a pump to ensure adequate circulation of the coolant, a coolant tank.

From the Chinese utility model CN202085372U an intelligent system for managing LED street lamps is known which is based on the concept of Internet of Things and comprises a control centre, a GPRS module, a central driver, an RF module, a LED street light intelligent terminal which comprises a voltage conversion module, an adjustable DC power supply, an LED street lighting, a temperature sensor, a light sensor, an infrared sensor, a microcontroller. The main advantages of the disclosed system include increase in electricity savings, increase in service life of street lamps, increase in reliability and safety of street lamps, ability to quickly detect system problems and timeliness of maintenance work.

From the Chinese utility model CN201204726Y, an automatic lighting control system for LED tunnel lamps is known. The system comprises a main power supply connected via an air circuit breaker to a logic module and a voltage regulation module. The signal generated by the logic module is passed to the voltage regulation module in order to control the voltage supplying the LED lamps. Furthermore, the system is equipped with a noise sensor and an infrared sensor. The present system solves the problem of lighting control, high energy consumption of lighting, and also reduces operating costs of the road tunnel.

From the Chinese utility model CN205666993U, a multi-functional intelligent street lamp is known, which comprises a body, an information gathering module, a central control module and a lighting module. Furthermore, the lamp comprises an external camera, an airborne dust sensor, a temperature and humidity sensor, a wind speed sensor, a noise sensor, a luminance sensor, the sensors being connected to the information gathering module. The said information gathering module is connected to the central module by the central control module. In turn, the central control module is connected to the wireless communication module and to the lighting module.

From the Chinese utility model CN205812460U, a LED street lamp is known, which is a node device adapted to work in a communication network. The said LED street light comprises a power and voltage stabilisation module, a host system, an ambient brightness monitoring module, an Ethernet module, a main control module, a lamp control module, and an LED lamp module, wherein the input of host system is connected to the ambient brightness monitoring module, and the output of the host system is connected to the LED lamp module through the LED street lamp control module. Furthermore, the host system is connected to the power and voltage stabilisation module and to the Ethernet module. Luminance of the LED street lamp can be remotely controlled with the use of pulse width modulation. As a result, this leads to an increase in energy efficiency of the LED street lamp.

From the Chinese patent CN103987180B a lighting control device is known. The said lighting control device comprises a power module and a sensor module connected to the power module. The sensor module is adapted to collect a signal relating to the condition of the object in the test area and an input signal of a single control module. The single control module is adapted to process the object condition signal in order to generate a signal controlling the LED lighting module. The control signal is input to the LED control module which is connected to the LED lighting module. Furthermore, the control device comprises a fault detection module adapted to detect an error signal of the LED lighting module and an error signal at the input of the single control module. The fault detection module is connected to the single control module which is adapted to analyse and process the error signal in order to generate an alarm signal. The control device also comprises a switch module the input of which is connected to the single control module and the output of which is connected to the LED lighting module. Moreover, the control device comprises a wireless communication unit equipped with a GSM module and a ZigBee wireless communication module. Control of the luminance level in the present solution is carried out with the use of PWM modulation. The present solution increases the energy efficiency of the LED lamp.

From the Chinese patent CN105960071B, an intelligent street lamp control system based on the ZigBee Light Link (ZLL) wireless network communication technology is known. The system comprises a host computer, a ZLL gate module and a ZLL street lamp node module. The ZLL gate module is responsible for maintaining the ZigBee Light Link protocol and the TCP/IP protocol. The ZLL gate module and the ZLL street lamp node module are connected in a tree topology. The ZLL node module comprises a power supply and a voltage stabilisation module, a main control module, an ambient brightness monitoring module, an LED street lamp control module and an LED street lamp module. The input of the main control module is connected to the ambient brightness monitoring module. In turn, the output of the main control module is sequentially connected to the LED street light control module and to the LED street light module. Furthermore, the main control module is connected to the power supply and to the voltage stabilisation module. The ZLL gate module comprises a power supply, a voltage stabilisation module, a main control module, and an Ethernet module, with the main control module being connected to the power supply, the voltage stabilisation module, and the Ethernet module. Control of the lighting in the present solution is carried out with the use of PWM modulation. The disclosed system makes it possible to reduce the energy consumption in relation to traditional street lamps and to automatically control the luminance of street lamps.

In the prior art LED light fittings, all blocks are functionally separated from each other, which only allows remote verification of the operating state of the communication module. Therefore, in the event of damage to any of the remaining functional blocks of the light fitting, it is not possible to immediately diagnose its fault, which may cause continuous heating of the light fitting until the intervention of technical personnel.

In existing LED light fittings, despite savings in electricity consumption, there is a problem of heat emission by LED matrices. Temperature increase negatively affects the performance and durability of LED matrices. Therefore, it is purposeful to optimise operating conditions of LED matrices in light fittings.

In known light fittings, in order to remove heat generated by LED matrices used inside them, usually cooling systems are used, which are often characterised by a large complex structure.

Nevertheless, there is still a need to further optimise the operating conditions of LED matrices in light fittings, especially in relation to ambient temperature of LED matrices.

### The Essence of the Invention

The object of the invention is implemented with an LED light fitting comprising a cover, an LED matrix, between which a cooling system is arranged, adapted to transport heat from the LED matrix to the cover, wherein the cooling system comprises a heat transfer plate connected to the LED matrix and a coolant circulation module connected to the heat transfer plate and to the cover. The said coolant circulation module comprises an evaporation section connected to the heat transfer plate and a condensation section connected to the inner surface of the cover, wherein the module comprises at least one channel with at least one chamber for transporting the coolant from the evaporation section to the condensation section and with at least one chamber for transporting the coolant from the condensation section to the evaporation section.

The structure of the light fitting according to the invention with the described cooling system increases the efficiency of dissipating the heat generated by the LED matrix, and as a result optimises the operating temperature of the said fitting.

Preferably, the chamber for transporting the coolant from the evaporation section to the condensation section or the chamber for transporting the coolant from the condensation section to the evaporation section is in the form of an inner pipe placed in the channel.

Preferably, the coolant circulation module comprises at least two parallel channels. Preferably, the channel is in the form of a pipe.

Preferably, the coolant circulation module is in the form of a plate in which at least one channel is formed.

Preferably, the coolant circulation module has a shape similar to the letter S or Z in its cross section.

The use of the coolant circulation module with ith cross-sectional shape similar to the letter S or Z allows obtaining the elasticity of the element ensuring its stable adhesion to the heat transfer plate and to the inner surface of the cover.

Preferably, the coolant circulation module is made of aluminium.

Preferably, projections in the form of ribs are provided on the outer surface of the cover so that the cover acts as a heat sink.

The use of projections in the form of ribs on the outer surface of the cover causes the air to move from the bottom to the top of the cover of the LED light fitting, and consequently effectively cools its sides.

Preferably, the heat transfer plate is about 1 mm thick. Preferably, the heat transfer plate is made of aluminium. Preferably, the coolant is a low-boiling liquid, e.g. R 123-4 agent.

The structure of the LED light fitting according to the invention reduces the consumption of material used for the production of the cooling system in relation to the prior art solutions, and thus reduces the cost of production such a system and, consequently, the cost of producing the light fitting.

The structure of the LED light fitting according to the invention reduces the amount of pollutants emitted to the environment during the production of such a light fitting.

The structure of the LED light fitting according to the invention allows the moving parts which are damaged more quickly than static elements to be eliminated from its interior.

The materials used for the production of the LED light fitting according to the invention ensure a high recycling rate, as over 80% of them can be reused.

The structure of the cooling system used in the light fitting according to the invention allows this system to be used in any LED light fitting.

The object of the invention is also implemented with an LED light fitting comprising an LED matrix, a communication module and a control and power supply system comprising a control microprocessor, a first voltage regulation module for lowering the mains voltage, a second voltage regulation module for controlling the light beam emitted by the LED matrix, wherein the output lᵢ of the first voltage regulation module is connected to the input sᵢ of the control microprocessor, where i = (1, 2, ... , n), the output tᵢ of the control microprocessor is connected to the input mᵢ of the second voltage regulation module, where i = (1, 2, ... , n), the output oᵢ of the second voltage regulation module is connected to the input uᵢ of the LED matrix, where i = (1, 2, ... , n), characterised in that the control microprocessor is adapted to continuous two-way communication with the communication module, and the control and power supply system further comprises a third voltage regulation module for supplying the remaining electrical components of the fitting, wherein tᵢ₊₁ the output of the control microprocessor is connected to the input pᵢ of the third voltage regulation module, where i = (1, 2, ... , n).

Preferably, the communication module is a GSM module.

Preferably, the fitting comprises at least one sensor of environmental parameters.

The use of the disclosed control and power supply system in the LED light fitting enables free control of the parameters of its individual functional blocks as well as remote diagnostics of its functional blocks. Remote diagnostics performed by this system allows changing the operating characteristics in the event of an increase in temperature or disconnecting individual functional blocks in the event of their overheating. As a result, the control and power supply system allows optimisation of the operating temperature of the said light fitting.

Furthermore, the control and power supply system also enables remote control of the light beam emitted by the LED matrix, which has a positive effect on the operating temperature and reduces electricity consumption.

The LED light fitting with the control and power supply system according to the invention also enables secure communication with the central server of the street light control system. The use of the control and power supply system according to the invention in the light fitting simplifies the operation of street light systems and, as a result, reduces the costs of maintenance.

What's more, the remote control of the LED matrix in the light fitting according to the invention allows the remote control of the power supplied to the matrix, thus enabling remote compensation of the flickering phenomenon.

The object of the invention is also a street light control system comprising at least one LED light fitting according to the second aspect of the invention and a central server.

### Description of the figures of the drawing

The object of the invention is shown in embodiments in the drawing, in which:

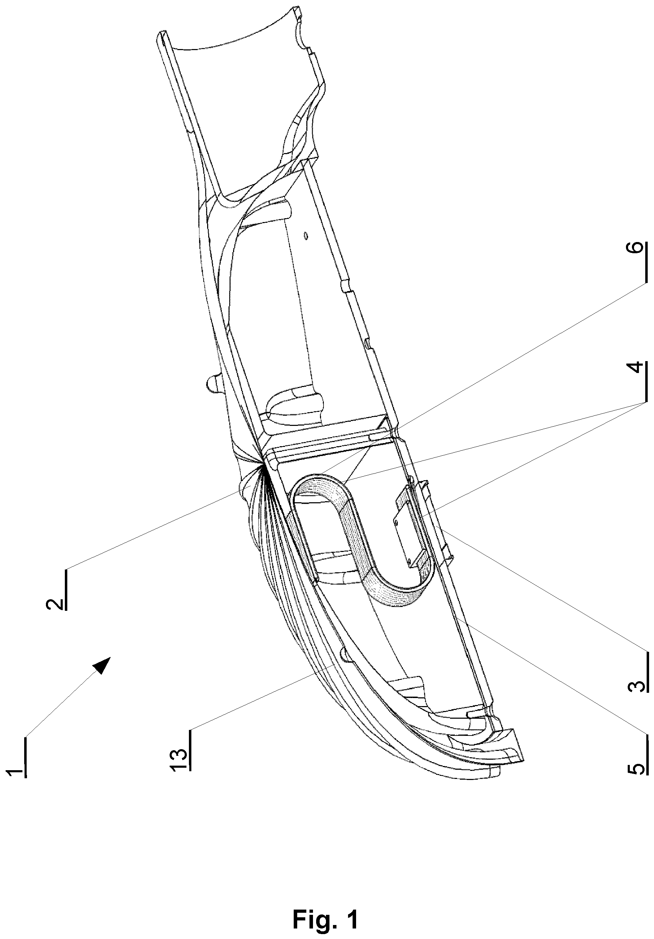

Fig. 1 is a cross-sectional view of a LED light fitting according to the invention;
Fig. 2 is a schematic view of a coolant circulation module used in the LED light fitting according to a first and a second embodiment of the invention;
Fig. 3 is a schematic view of a coolant circulation module used in the LED light fitting according to a third embodiment of the invention;
Fig. 4 is a perspective cross-sectional view of the coolant circulation module with a visible channel for for an inner pipe according to the third embodiment of the invention;
Fig. 5 is a schematic view of a control and power supply system used in the LED light fitting according to a fifth embodiment of the invention;

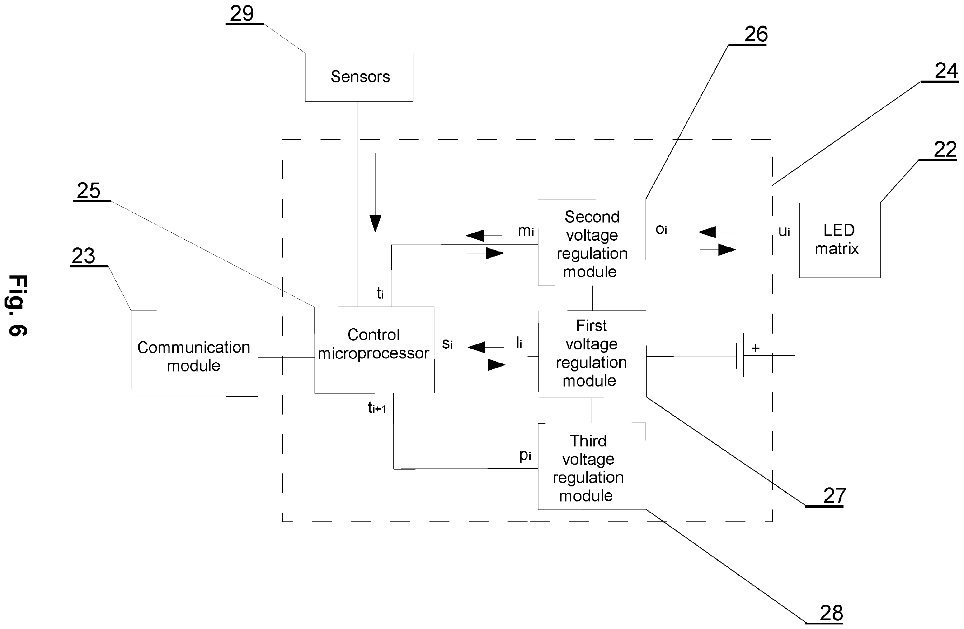

Fig. 6 is a schematic view of the control and power supply system used in the LED light fitting according to a sixth embodiment of the invention;

### Detailed description of the invention First embodiment

An LED light fitting 1 according to a first embodiment comprises a cover 2, an LED matrix 3 between which a cooling system 4 is arranged, adapted to transport heat from the LED matrix 3 to the cover 2.

The cover 2 is adapted to transfer heat to the environment by convection and thus acts as a heat sink. The said cover 2 can be made of silumin and have a thickness of about 4 mm. In turn, the LED matrix 3 can be made in Chip-On-Board technology and comprise low-voltage diodes with rated voltages of 30V to 40V.

The cooling system 4 comprises a heat transfer plate 5 connected to the LED matrix 3 and a coolant circulation module 6 connected to the heat transfer plate 5 and to the cover 2. The heat transfer plate 5 can be made of aluminium and have a thickness of about 1 mm.

The coolant circulation module 6 is filled, for example, with a low-boiling liquid, preferably in the form of R 123-4 agent, and comprises an evaporation section 7 connected to the heat transfer plate 5 and a condensation section 8 connected to the inner surface of the cover 2.

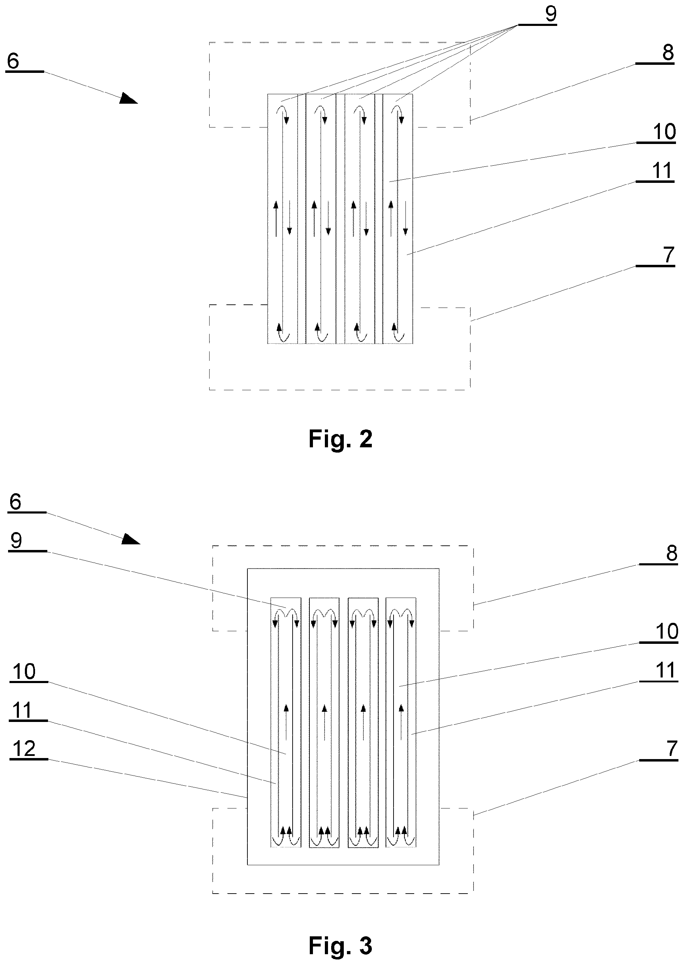

As shown in fig. 2, the coolant circulation module 6 comprises four channels 9 in the form of parallel pipes, each channel comprising one chamber 10 for transporting the coolant from the evaporation section 7 to the condensation section 8 and one chamber 11 for transporting the coolant from the condensation section 8 to the evaporation section 7. The chambers 10 and 11 are defined by a wall placed in the channel 9, the length of which is less than the length of the channel 9.

The said heat transfer plate 5 transfers heat from the LED matrix 3 to the evaporation section 7 of the coolant circulation module 6, as a result of which the coolant heats up and, over time, begins to evaporate. As a result of this physical transformation, the coolant is transported in each of the channels 9, through the chambers 10, to the condensation section 8, where heat is transferred to the cover 2, as a result of which the coolant condenses and flows back by gravity through the chambers 11 to the evaporation section 7 for subsequent heating.

The coolant circulation module 6 has a shape similar to the letter S or Z in its cross section and is made of aluminium. The use of the said shape of the coolant circulation module 6 makes it possible to obtain the elasticity of the element ensuring its stable adhesion to the heat transfer plate 5 and to the inner surface of the cover 2, which optimises heat exchange between the individual elements.

The use of the cooling system 4 in light fittings increases the efficiency of dissipating the heat generated by the LED matrix 3.

The cooling system 4 is applicable in particular in light fittings with a source power above 30W.

### Second embodiment

The second embodiment of the LED light fitting is as in the first embodiment, with the difference that the coolant circulation module 6 has a shape similar to the letter Z in its cross section. This shape, as in the case of the module 6 with its cross-section similar to the letter S, allows obtaining the elasticity of the module 6 ensuring its stable adhesion to the heat transfer plate 5 and to the inner surface of the cover 2.

### Third embodiment

The third embodiment of the LED light fitting is as in the first or second embodiment, with the difference that the coolant circulation module 6 (shown schematically in Fig. 3) is in the form of a plate 12, with four hollow channels 9 with chambers 10 for transporting the coolant from the evaporation section 7 to the condensation section 8 being in the form of inner pipes placed in the channel 9. The length of the inner pipes is smaller than the length of the channels 9.

In an alternative embodiment of the invention, the chambers 11for transporting the coolant from the condensation section 8 to the evaporation section 7are in the form of inner pipes placed in the channels 9.

### Fourth embodiment

The fourth embodiment of the LED light fitting is as in any of the preceding embodiments, with the difference that projections 13 in the form of ribs are provided on the outer surface of the cover 2. Such a structure causes the air to move from the bottom to the top of the cover 2 of the LED light fitting 1, and consequently effectively cools its sides.

### Fifth embodiment

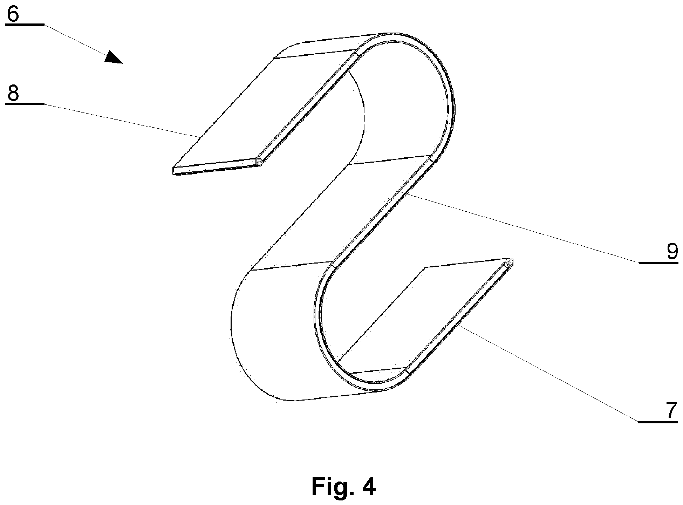

Fig. 4 shows schematically the control and power supply system 24 adapted to control the LED matrix 22 of the light fitting and to cooperate with a communication module 23. The control and power supply system 24 can of course be used with both the light fittings according to any of the preceding embodiments and with other types of light fittings. The LED matrix 22 can be made in Chip-On-Board technology and comprise low-voltage diodes with rated voltages of 30V to 40V. The communication module 23, which may be a radio module, and in particular a GSM module, enables the operation of the LED light fitting in a street light control system based on the Internet of Things (loT) concept and comprising a central server. The control and power supply system 24 comprises a control microprocessor 25, a first voltage regulation module 26 for reducing the mains voltage, a second voltage regulation module 27 for controlling the light beam emitted by the LED matrix 22, and a third voltage regulation module 28 for powering the remaining electrical components of the fitting. The remaining electrical components of the fitting 21 are understood to be electrical components contained in the LED light fitting but not mentioned in the present description due to the fact that they do not relate to the essence of the solution.

The output lᵢ of the first voltage regulation module 26 is connected to the input sᵢ of the control microprocessor 25, where i = (1, 2,..., n). The output tᵢ of the control microprocessor 25 is connected to the input mᵢ of the second voltage regulation module 27, where i = (1, 2,..., n), and the output oᵢ of the second voltage regulation module 27 is connected to the input uᵢ of the LED matrix 22, where i = (1, 2, ... , n). In turn, the output tᵢ₊₁ of the control microprocessor 25 is connected to the input pᵢ of the third voltage regulation module 28, where i = (1, 2,... , n). Thus, the first voltage regulation module 26 is adapted to power the second voltage regulation module 27. As a result, the parameters of the first voltage regulation module 26 are adapted to the parameters of the second voltage regulation module 27, and consequently the performance parameters of the LED light fitting are improved. Furthermore, the voltage regulation modules 26, 27, 28 are connected directly to the control microprocessor 25, so the way they operate is determined by the control microprocessor 25. Moreover, the control microprocessor 25 is adapted for continuous two-way communication with the communication module 23. As a result, the disclosed solution makes it possible to carry out remote diagnostics of individual functional blocks of the LED lighting fitting and to remotely control the power parameters of the light fitting, for example so that the selected element of the fitting is cooled down or is not further damaged. Furthermore, the disclosed solution allows for remote control of the light beam emitted by the LED matrix 22. Moreover, the adaptation of the LED light fitting to operate in the street light control system, and consequently its remote diagnostics, allows such a light fitting to be controlled by means of actual parameter of the light beam.

As mentioned, the disclosed solution allows remote diagnostics to be performed on individual functional blocks of the LED light fitting. Thus, it is possible to diagnose the communication module 23 and the control microprocessor 25. Lack of data transmission between the central server and the communication module 23 means a failure of the communication module 23 or lack of transmission capabilities in the street light control system. Tools delivered by telecommunications network operators can be used to diagnose the communication module 23. For example, it is possible to verify whether the said module has logged into any of the base stations in the telecommunications network. On the other hand, lack of data transmission between the communication module 23 and the control microprocessor 25 in the case of correct operation of the said module means damage to the control microprocessor 25.

Furthermore, the disclosed solution allows remote diagnostics to be performed on the first voltage regulation module 26 and the functions thereof to be taken over by the second voltage regulation module 27 while maintaining correspondingly lower power at which the electrical components of the fittings operate.

Moreover, the present solution allows diagnostics of the second voltage regulation module 27 to be performed, taking into account the state of the LED matrix 22 and its parameters. This is due to the fact that the current control of the LED matrix 22 is related to the presence of a certain forward voltage on its terminals, which allows determining whether the said matrix is, for example, overheated, shortcircuited, open or partially damaged, which optimises operating conditions of the matrix. Moreover, remote control of the LED matrix 22, and thus regulation of power supplied to it, enables remote compensation of the flickering phenomenon.

The operation of the LED light fitting in the street light control system makes it possible to collect data on of lamp operation statistics on the central server, which allows obtaining information, for example, whether the light fitting was heated more in its interior on a given day than in the previous 3 days. Thus, the LED light fitting 21 is a highly efficient light source.

### Sixth embodiment

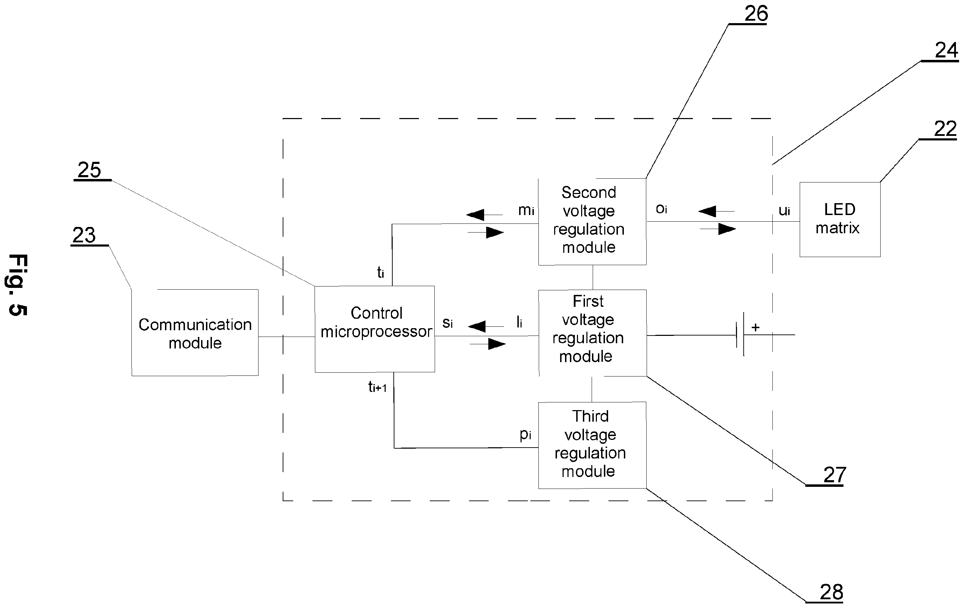

Fig. 5 shows schematically the control and power supply system 24 as in the fifth embodiment, with the difference that the LED light fitting comprises sensors 29 of environmental parameters. These can be sensors of temperature, solar radiation intensity, humidity, air quality. For example, the control microprocessor 25 can calculate, based on the data from the solar radiation intensity sensor, the amount of light that the LED light fitting should deliver within a given area while maintaining the required lighting parameter at ground level. Thus, the LED light fitting allows regulation of the amount of light delivered, depending on the glow of the surroundings.

## Claims

1. An LED light fitting (1), comprising:
- a cover (2),
- an LED matrix (3),
- between which a cooling system (4) is arranged, adapted to transport heat from the LED matrix (3) to the cover (2),
**characterised in that**
- the cooling system (4) comprises:
- a heat transfer plate (5) connected to the LED matrix (3),
- and a coolant circulation module (6) connected to the heat transfer plate (5) and to the cover (2), comprising:
- an evaporation section (7) connected to the heat transfer plate (5),
- and a condensation section (8) connected to the inner surface of the cover (2),
wherein the module (6) comprises at least one channel (9) with:
- at least one chamber (10) for transporting the coolant from the evaporation section (7) to the condensation section (8),
- and at least one chamber (11) for transporting the coolant from the condensation section (8) to the evaporation section (7).

2. The fitting according to claim 1, **characterised in that** the chamber (10) for transporting the coolant from the evaporation section (7) to the condensation section (8) or the chamber (11) for transporting the coolant from the condensation section (8) to the evaporation section (7) is in the form of an inner pipe placed in the channel (9).

3. The fitting according to any of the preceding claims, **characterised in that** the coolant circulation module (6) comprises at least two parallel channels (9).

4. The fitting according to any of the preceding claims, **characterised in that** the channel (9) is in the form of a pipe.

5. The fitting according to any of the claims 1 to 3, **characterised in that** the coolant circulation module (6) is in the form of a plate (12) in which at least one channel (9) is formed.

6. The fitting according to any of the preceding claims, **characterised in that** the coolant circulation module (6) has a shape similar to the letter S or Z in its cross section.

7. The fitting according to any of the preceding claims, **characterised in that** the coolant circulation module (6) is made of aluminium.

8. The fitting according to any of the preceding claims, **characterised in that** projections (13) in the form of ribs are arranged on the outer surface of the cover (2).

9. The fitting according to any of the preceding claims, **characterised in that** the heat transfer plate (5) is about 1 mm thick.

10. The fitting according to any of the preceding claims, **characterised in that** the heat transfer plate (5) is made of aluminium.

11. The fitting according to any of the preceding claims, **characterised in that** the coolant is a low-boiling liquid.

12. An LED light fitting, comprising:
- an LED matrix (22),
- a communication module (23),
- a control and power supply system (24) comprising:
- a control microprocessor (25),
- a first voltage regulation module (26) for lowering the mains voltage,
- a second voltage regulation module (27) for controlling the light beam emitted by the LED matrix (22),
wherein
- the output lᵢ of the first voltage regulation module (26) is connected to the input sᵢ of the control microprocessor (25), where i = (1, 2, ..., n);
- the output tᵢ of the control microprocessor (25) is connected to the input mᵢ of the second voltage regulation module (27), where i = (1, 2, ... , n);
- the output oᵢ of the second voltage regulation module (27) is connected to the input uᵢ of the
LED matrix (22), where i = (1, 2, ... , n);
**characterised in that**
- the control microprocessor (25) is adapted for continuous two-way communication with the communication module (23), and
- the control and power supply system (24) further comprises:
a third voltage regulation module (28) for powering the remaining electrical components of the fitting (21), wherein tᵢ₊₁ the output of the control microprocessor (25) is connected to the input pᵢ of the third voltage regulation module (28), where i = (1, 2, ... , n).

13. The fitting according to claim 12, **characterised in that** the communication module is a GSM module.

14. The fitting according to claim 12 or 13, **characterised in that** it comprises at least one sensor (29) of environmental parameters.

15. A street light control system comprising at least one LED light fitting according to any of the claims 11 to 13 and a central server.
